# EUROPÄISCHE PATENTSCHRIFT

(11) **EP 2 845 453 B1**
(45) Veröffentlichungstag und Bekanntmachung des Hinweises auf die Patenterteilung: **12.06.2019**
(21) Anmeldenummer: 13720750.2
(22) Anmeldetag: 15.04.2013
(51) Int. Cl.: H05K 1/02, H01L 23/492, H01L 25/07, H02M 7/00, H05K 1/05, H05K 1/09, H01L 25/18, H05K 3/46, H05K 7/02, H05K 7/04

(54) **LEITERPLATTE, INSBESONDERE FÜR EIN LEISTUNGSELEKTRONIKMODUL, UMFASSEND EIN ELEKTRISCH LEITFÄHIGES SUBSTRAT**
CIRCUIT BOARD, PARTICULARLY FOR A POWER-ELECTRONIC MODULE, COMPRISING AN ELECTRICALLY-CONDUCTIVE SUBSTRATE
CARTE DE CIRCUIT IMPRIMÉ, NOTAMMENT POUR UN MODULE D'ÉLECTRONIQUE DE PUISSANCE, COMPORTANT UN SUBSTRAT ÉLECTROCONDUCTEUR

(30) Priorität: 04.05.2012 AT 5262012
(43) Veröffentlichungstag der Anmeldung: 11.03.2015
(73) Patentinhaber: A.B. Mikroelektronik Gesellschaft mit beschränkter Haftung, 5020 Salzburg (AT)
(72) Erfinder: BURNS, Robert, Christopher, A-5020 Salzburg (AT); TUSLER, Wolfgang, A-5020 Salzburg (AT); HAEGELE, Bernd, 84549 Engelsberg (DE)
(74) Vertreter: Torggler & Hofinger Patentanwälte
(86) Internationale Anmeldenummer: PCT/AT2013/000063
(87) Internationale Veröffentlichungsnummer: WO 2013/163664

(56) Entgegenhaltungen:
- CN-A- 101 593 707
- CN-U- 201 657 572
- CN-U- 201 986 264
- DE-A1- 10 101 086
- JP-A- H0 414 852
- JP-A- H01 112 793
- JP-A- H04 164 384
- JP-A- 2000 058 717
- JP-A- 2004 319 562
- JP-A- 2006 049 542
- US-A- 4 993 148
- US-A1- 2005 277 550
- US-A1- 2006 160 330
- US-A1- 2009 004 369

## Beschreibung

Die Erfindung betrifft eine Leiterplatte mit den Merkmalen des Oberbegriffs des Anspruchs 1. Weiters betrifft die Erfindung ein Leistungselektronikmodul umfassend wenigstens eine Leiterplatte sowie ein Verfahren zur Herstellung einer Leiterplatte.

Eine gattungsgemäße Leiterplatte ist beispielsweise aus der Druckschrift JP 2004 319562 A bekannt, welche ein Invertermodul umfassend Substrate in Form von Elektrodenplatten offenbart, die aus Aluminium bestehen können.

Die Druckschrift JP 2006 049542 A offenbart ein Leistungselektronikmodul, dessen Elektrodenplatten jedoch nicht aus Aluminium sind.

Der Werkstoff Aluminium erfährt insbesondere im Bereich der Leistungselektronik eine zunehmend höhere Bedeutung. Durch sein verhältnismäßig geringes Gewicht und die geringen Kosten wird Aluminium häufig als Kühlkörper für elektronische Bauteile (z.B. LEDs, IGBTs oder MOSFETs) in Leistungselektronikmodulen oder auch direkt als stromführender Leiter, insbesondere als Strom- oder Sammelschiene, eingesetzt. Aluminium weist für diese Einsatzzwecke sowohl eine sehr hohe Wärmeleitfähigkeit als auch eine sehr hohe elektrische Leitfähigkeit auf.

Im Bereich der Leistungselektronik wird als Substrat häufig ein isoliertes Metallsubstrat (auf Englisch "insulated metal substrate", kurz IMS) eingesetzt, welches einen Kern aus Aluminium umfasst und welches von einer elektrisch isolierenden bzw. dielektrischen Schicht umhüllt ist. Der Kern aus Aluminium wird in diesem Fall ausschließlich für eine verbesserte Wärmeleitung eingesetzt. Die Leiterbahnen selbst sind auf der Isolierschicht angeordnet und elektrisch nicht mit dem Kern aus Aluminium kontaktiert.

Aufgabe der Erfindung ist es, eine gattungsgemäße Leiterplatte bereitzustellen, auf der elektronische Bauteile mit einem Substrat der Leiterplatte elektrisch kontaktierbar anordenbar sind. Insbesondere soll ein elektronisches Bauteile an einem Substrat einer Leiterplatte, das überwiegend aus Aluminium und/oder einer Aluminiumlegierung besteht, anlötbar sein, um eine elektrische Kontaktierung des elektronischen Bauteils mit dem Substrat herstellen zu können.

Diese Aufgabe wird erfindungsgemäß durch die Merkmale des Patentanspruchs 1 gelöst. Vorteilhafte Ausgestaltungen der Erfindung sind in den abhängigen Patentansprüchen angegeben.

Gemäß der Erfindung ist also vorgesehen, dass auf wenigstens einer Oberfläche des elektrisch leitfähigen Substrats wenigstens eine Leiterfläche in Form einer, vorzugsweise durch ein Druckverfahren, besonders bevorzugt durch ein Siebdruckverfahren, aufgebrachten, elektrisch leitfähigen Schicht angeordnet ist, wobei die Leiterfläche direkt mit dem elektrisch leitfähigen Substrat elektrisch kontaktiert ist.

Ein Ziel der Erfindung ist es, eine direkte elektrische Kontaktierung von auf dem Substrat angeordneten Leiterflächen bzw. Leiterbahnen mit dem Substrat selbst zu erzielen und das Substrat als elektrischen Leiter zu verwenden. Bei der vorgeschlagenen Leiterplatte ist eine elektrisch leitfähige Leiterfläche, die im Wesentlichen aus Kupfer bestehen kann und eine Dicke von 25 µm bis 125 µm, vorzugsweise von 90 µm bis 110 µm, aufweisen kann, direkt an einer Oberfläche des elektrisch leitfähigen Substrats angeordnet. Es kann also auf eine zwischen Substrat und Leiterfläche angeordnete Isolierschicht verzichtet werden. Dadurch kann einerseits ein vereinfachter Aufbau der Leiterplatte erzielt werden, wodurch sich eine Leiterplatte auch kostengünstiger herstellen lässt. Andererseits kann dadurch das Substrat zusätzlich zu seiner Funktion als wärmeabführende Vorrichtung auch als stromführender Teil der Leiterplatte verwendet werden. Dies ist insbesondere bei Leistungselektronikmodulen und den bei diesen auftretenden hohen elektrischen Strömen von Vorteil.

Gemäß einer besonders bevorzugten Ausführungsform kann vorgesehen sein, dass die wenigstens eine Oberfläche des elektrisch leitfähigen Substrats im Wesentlichen eben ausgebildet ist. Dadurch lässt sich der Herstellungsprozess einer Leiterplatte wesentlich vereinfachen. So können beispielsweise herkömmliche Aluminiumplatten mit einer Dicke von etwa 1 mm bis 3 mm einfach je nach Bedarf geschnitten, gesägt oder ausgestanzt werden, ohne die Oberflächen der Aluminiumplatten speziell behandeln zu müssen.

In einer bevorzugten Ausführungsform der Erfindung kann vorgesehen sein, dass auf der wenigstens einen Oberfläche des elektrisch leitfähigen Substrats wenigstens eine Isolatorfläche in Form einer, vorzugsweise durch ein Druckverfahren - besonders bevorzugt durch ein Siebdruckverfahren - aufgebrachten, dielektrischen Schicht angeordnet ist. Dabei kann die wenigstens eine Isolatorfläche zumindest teilweise an der wenigstens einen Leiterfläche angrenzen, vorzugsweise die wenigstens eine Leiterfläche umgeben.

Um einen Funkenüberschlag zwischen strom- bzw. spannungsführenden Teilen und einen damit verbundenen Kurzschluss zu verhindern, müssen diese in einem bestimmten Abstand zueinander angeordnet werden. Beispielsweise soll der Abstand bzw. die Luftstrecke zwischen zwei spannungsführenden Teilen bei einer Spannungsdifferenz von 400 V gemäß der Norm DIN EN 60664-1 VDE 0110-1 mindestens 4 mm betragen. Durch die Isolatorfläche kann der Abstand zu anderen stromführenden Teilen, beispielsweise zu anderen Leiterplatten innerhalb eines Leistungselektronikmoduls, bei gleicher Spannungsfestigkeit verringert werden, beispielsweise auf unter 1 mm. Dadurch können Baugrößen von Leistungselektronikmodulen, die wenigstens eine vorgeschlagene Leiterplatte umfassen, reduziert werden.

Die Dicke der Isolatorfläche kann je nach auszulegender Überschlagspannung gewählt werden. Bei einer durchschnittlichen Überschlagspannung der dielektrischen Schicht von 800 V pro 25 µm ist üblicherweise eine Dicke von 100 µm für die Isolatorfläche ausreichend. Generell kann die Dicke der dielektrischen Schicht abhängig von der Überschlagspannung eines verwendeten und z.B. zwischen zwei Leiterplatten angeordneten IGBT gewählt werden und beispielsweise für Hochspannungsanwendungen derart gewählt werden, dass eine Überschlagspannung von etwa 600 V bis etwa 1700 V erzielt wird.

Generell kann die Isolatorfläche auch als Lötabdeckung für die wenigstens eine Leiterfläche dienen. Daher kann die wenigstens eine Isolatorfläche in einem solchen Muster auf das Substrat aufgetragen werden, sodass die wenigstens eine Leiterfläche bzw. eine Mehrzahl von Leiterflächen von der Isolatorfläche umgeben bzw. umrahmt sind.

Zur Herstellung der wenigstens einen Isolatorfläche auf dem Substrat kann vorgesehen sein, dass auf der wenigstens einen Oberfläche des Substrats zumindest bereichsweise eine dielektrische Schicht aufgebracht wird. Dabei kann durch ein Druckverfahren, vorzugsweise durch ein Siebdruckverfahren, eine dielektrische Dickschichtpaste aufgebracht werden. Die Dickschichtpaste kann bei Temperaturen unter etwa 200 °C für ca. 10 min getrocknet werden oder direkt in einem Brennofen gesintert werden.

Das Brennen bzw. Sintern der Dickschichtpaste kann unter Luftatmosphäre bei Temperaturen zwischen etwa 540 °C und etwa 640 °C in einem Brennofen erfolgen. Es ist auch möglich, die Dickschichtpaste bei Temperaturen unter 540 °C zu brennen, jedoch kann sich dies nachteilig auf die Anhaftung der Dickschichtpaste am Substrat auswirken. Bei einem Brennen der Dickschichtpaste über 640 °C kann das Substrat beginnen, sich aufzuweichen, da der Schmelzpunkt von Aluminium bei etwa 660 °C liegt.

Um eine günstige Anhaftung der Dickschichtpaste am Substrat zu erreichen, können Glasbestandteile der Dickschichtpaste wenigstens ein Alkalimetalloxid umfassen, z.B. Lithiumoxid, Natriumoxid oder Kaliumoxid. Dadurch schmelzen die Glasbestandteile bereits bei Temperaturen unterhalb des Schmelzpunkts von Aluminium. Darüber hinaus kann durch das Vorhandensein von Alkalimetalloxiden auch der Ausdehnungskoeffizient der Dickschichtpaste erhöht und/oder an den Ausdehnungskoeffizienten von Aluminium angepasst werden.

Eine vorgeschlagene Leiterplatte ist besonders dazu geeignet, in kompakten Leistungselektronikmodulen, z.B. in Hochstrom-Mehrphasen-Leistungsbrücken oder Wechselrichtern, eingesetzt zu werden. Bei solchen Leistungselektronikmodulen kommen häufig elektronische Schalter bzw. Transistoren in Form von Bipolartransistoren mit isolierten Gate-Elektroden (auf Englisch "insulated-gate bipolar transistor", kurz IGBT) zum Einsatz. Für den Anschluss einer solchen Gate-Elektrode kann vorgesehen sein, dass auf der wenigstens einen Isolatorfläche wenigstens eine Anschlussfläche in Form einer elektrisch leitfähigen Schicht angeordnet ist. Die Anschlussfläche kann in weiterer Folge mit dem Gate-Anschluss eines IGBTs verbunden werden, z.B. durch Verlöten.

Schutz wird auch begehrt für ein Leistungselektronikmodul nach Anspruch 12. Vorteilhafte Ausgestaltungen sind in den davon abhängigen Patentansprüchen angegeben.

Eine vorgeschlagene Leiterplatte kann Teil eines Leistungselektronikmoduls sein, beispielsweise eines Wechselrichters. Solche Wechselrichter werden unter anderem bei hybriden oder vollelektrischen Antriebssträngen im Automobilbereich eingesetzt, um die Gleichspannung einer Gleichspannungsquelle (z.B. Batterie) in eine 3-Phasen-Wechselspannung für einen Drehstrommotor umzusetzen. Der Wechselrichter selbst kann dabei sechs elektronische Schalter (z.B. IGBTs) und damit korrespondierende Freilaufdioden umfassen. Durch entsprechende Ansteuerung der Gate-Anschlüsse der IGBTs kann dabei eine an den Wechselrichter angeschlossene Gleichspannung, beispielsweise im Bereich von etwa 300 V bis 1200 V, in bekannter Art und Weise in drei phasenverschobene Wechselspannungen umgerichtet und einem Drehstrommotor zugeführt werden.

Gemäß einer besonders bevorzugten Ausführungsform kann ein vorgeschlagenes Leistungselektronikmodul eine erste Leiterplatte, eine zweite Leiterplatte und drei dritte Leiterplatten umfassen.

Für die erste Leiterplatte kann vorgesehen sein, dass auf der wenigstens einen Oberfläche des elektrisch leitfähigen Substrats eine Mehrzahl von Leiterflächen, vorzugsweise sechs Leiterflächen, angeordnet sind, wobei vorzugsweise die Leiterflächen von einer Isolatorfläche umgeben sind. An den Leiterflächen können beispielsweise drei IGBTs und drei damit korrespondierende Freilaufdioden angebracht werden, z.B. durch Anlöten. Die erste Leiterplatte kann beispielsweise als negativ gepolte Stromschiene eines Wechselrichters ausgebildet sein, die mit dem negativen Pol einer Gleichspannungsquelle verbindbar ist.

Für die zweite Leiterplatte kann zusätzlich vorgesehen sein, dass auf der Isolatorfläche eine Mehrzahl von Anschlussflächen, vorzugsweise drei Anschlussflächen, angeordnet sind. Dadurch lassen sich zusätzlich zur Anbringung von drei IGBTs und drei damit korrespondierenden Freilaufdioden an die Leiterflächen auch die Gate-Elektroden der IGBTs mit den Anschlussflächen verbinden, z.B. durch Anlöten, und in weiterer Folge ansteuern. Die zweite Leiterplatte kann beispielsweise als positiv gepolte Stromschiene eines Wechselrichters ausgebildet sein, die mit dem positiven Pol einer Gleichspannungsquelle verbindbar ist.

Für jede der drei dritten Leiterplatten kann vorgesehen sein, dass auf einer ersten Oberfläche des elektrisch leitfähigen Substrats eine Mehrzahl von Leiterflächen, vorzugsweise zwei Leiterflächen, angeordnet sind und dass auf einer zweiten Oberfläche des elektrisch leitfähigen Substrats eine Mehrzahl von Leiterflächen, vorzugsweise zwei Leiterflächen, sowie wenigstens eine Isolatorfläche angeordnet sind, wobei auf der wenigstens einen Isolatorfläche eine Anschlussfläche angeordnet ist.

Jede der drei dritten Leiterplatten kann dabei als Phasenanschluss eines Wechselrichters für einen Drehstrommotor ausgebildet sein. Die zwei Leiterflächen der ersten Oberfläche einer dritten Leiterplatte können dabei mit je einem Paar elektronischer Bauteile - umfassend einen IGBT und eine damit korrespondierende Freilaufdiode - die an der zweiten Leiterplatte angeordnet sein können, verbunden werden, z.B. durch Löten. Die zwei Leiterflächen und die Anschlussfläche der zweiten Oberfläche einer dritten Leiterplatte können dabei mit je einem Paar elektronischer Bauteile - umfassend einen IGBT und eine damit korrespondierende Freilaufdiode - die an der ersten Leiterplatte angeordnet sein können, verbunden werden, z.B. durch Löten. Die Anschlussfläche kann dabei jeweils zur Verbindung der Gate-Elektrode eines IGBTs dienen.

Als besonders vorteilhaft hat es sich herausgestellt, wenn die Leiterplatten im Wesentlichen gestapelt angeordnet sind, wobei die drei dritten Leiterplatten, vorzugsweise nebeneinander liegend, zwischen der ersten Leiterplatte und der zweiten Leiterplatte angeordnet sind. Dadurch kann eine sehr kompakte Bauform eines Leistungselektronikmoduls erzielt werden.

In einer besonders bevorzugten Ausführungsform kann vorgesehen sein, dass das Leistungselektronikmodul als Hochstrom-Mehrphasen-Leistungsbrücke ausgebildet ist, wobei auf der wenigstens einen Oberfläche der ersten Leiterplatte und/oder den zweiten Oberflächen der drei dritten Leiterplatten drei Transistoren, vorzugsweise IGBTs, und drei Freilaufdioden angebracht, vorzugsweise angelötet, sind und wobei auf der wenigstens einen Oberfläche der zweiten Leiterplatte und/oder den ersten Oberflächen der drei dritten Leiterplatten drei Transistoren, vorzugsweise IGBTs, und drei Freilaufdioden angebracht, vorzugsweise angelötet, sind.

Das Anlöten von elektronischen Bauteilen wie z.B. IGBTs und Freilaufdioden auf einer vorgeschlagenen Leiterplatte kann vorzugsweise durch Dampfphasenlöten erfolgen. Dadurch kann in den Lötschichten eines Leistungselektronikmoduls ein einheitlicher Temperaturgradient erzielt werden. Bei einem gestapelten Wechselrichter können eine erste Lötschicht zwischen der ersten Leiterplatte und den drei dritten Leiterplatten und eine zweite Lötschicht zwischen den drei dritten Leiterplatten und der zweiten Leiterplatte angeordnet sein.

Generell kann eine Leiterfläche auf die Oberfläche eines Substrats durch verschiedene Verfahren aufgebracht werden, wie beispielsweise durch galvanische Prozesse, Plasma-Metall-Sprays oder durch Plattieren (z.B. Walzplattieren).

Schutz wird auch begehrt für ein Verfahren zur Herstellung einer Leiterplatte nach Anspruch 15.

Eine chemische Eigenschaft von Aluminium ist eine sich sehr schnell an der Luft bildende dünne Oxidschicht, die sich durch Kontakt mit Sauerstoff in der Atmosphäre in Folge eines Oxidationsprozesses an der Oberfläche eines Aluminiumkörpers bildet. Diese Oxidschicht bietet zwar einerseits einen Korrosionsschutz, erschwert aber andererseits die Verbindung von Aluminium mit anderen Werkstoffen durch Löten, Schweißen oder andere bekannte Verbindungstechniken.

Zur Herstellung einer vorgeschlagenen Leiterplatte, insbesondere zur Herstellung der wenigstens einen Leiterfläche auf dem Substrat, kann daher vorgesehen sein, dass auf einer Oberfläche des Substrats zumindest bereichsweise eine Leiterpaste aufgebracht wird, in einer ersten Brennphase die Leiterpaste einer im Wesentlichen kontinuierlich steigenden Brenntemperatur ausgesetzt wird, wobei die Brenntemperatur auf eine vorgebbare maximale Brenntemperatur kleiner etwa 660 °C erhöht wird, in einer zweiten Brennphase die Leiterpaste für einen vorgebbaren Zeitraum im Wesentlichen der vorgebbaren maximalen Brenntemperatur ausgesetzt wird, in einer Abkühlphase die Leiterpaste abgekühlt wird und in einer Nachbehandlungsphase eine Oberfläche der Leiterpaste mechanisch nachbehandelt, vorzugsweise gebürstet, wird.

Die Bereiche, an denen die Leiterpaste aufgebracht und entsprechend den Verfahrensschritten gesintert wird, treten zur elektrischen Kontaktierung des Substrats anstelle der in diesem Bereich vorherrschenden, oxidierten Oberfläche des Substrats. Diese elektrisch leitfähige Schicht, die zumindest bereichsweise durch das Auftragen und Sintern der Leiterpaste erzielt wird, kann in weiterer Folge beispielsweise zum Anlöten eines elektronischen Bauteils oder auch zum Anlöten eines Kühlkörpers verwendet werden, wobei der Kühlkörper selbst wiederum aus Aluminium bestehen kann.

Das Substrat kann dabei zumindest teilweise, vorzugsweise vollständig, aus einem Aluminium-Werkstoff mit einem möglichst hohen Aluminium-Anteil bestehen. Vorzugsweise kommt ein Aluminium-Werkstoff mit der Güte EN AW-1050A oder EN AW-1060A nach Europäischer Norm EN 573 zum Einsatz, der mindestens 99,5 Gew.-% bzw. 99,6 Gew.-% Aluminium enthält. Trotz etwas geringerer Liquidustemperaturen und geringerer Wärmeleitfähigkeit im Vergleich zu den vorgenannten im Wesentlichen puren Aluminium-Werkstoffen können auch Aluminiumlegierungen eingesetzt werden, beispielsweise Aluminiumlegierungen umfassend Mangan oder Magnesium wie z.B. EN AW-3003 (AlMn1Cu) EN AW-3103 (AlMn1), EN AW-5005 (AlMg1) oder EN AW-5754 (AlMg3).

Durch das beschriebene Herstellungsverfahren erhält man die Möglichkeit, selektiv einzelne Bereiche der Oberfläche eines Aluminium-basierten Substrats zu metallisieren, wobei die metallisierten Bereiche in Form einer gesinterten Leiterpaste direkt stoffschlüssig mit dem Substrat verbunden sind und sich dadurch eine hohe elektrische Leitfähigkeit und eine hohe thermische Leitfähigkeit von Leiterpaste zu Substrat und umgekehrt erzielen lässt. Die metallisierten Bereiche stellen darüber hinaus lötbare Bereiche dar, durch die das Substrat in bekannter Art und Weise mit weiteren Komponenten verbunden werden kann. So können beispielsweise unter Verwendung von herkömmlichen Lötmitteln wie eutektischen Sn-Pb-, Sn-Ag-Cu- oder Sn-Au-Loten einzelne elektronische Bauteile auf die metallisierten Bereiche aufgelötet werden.

Gemäß einer besonders bevorzugten Ausführungsform kann vorgesehen sein, dass die Leiterpaste durch ein Druckverfahren, vorzugsweise durch ein Siebdruckverfahren, auf die Oberfläche des Substrats aufgebracht wird.

Dabei können herkömmliche Leiterpasten in Form von Dickschichtpasten oder Sinterpasten eingesetzt werden. Durch die Porosität von Dickschichtpasten können unterschiedliche Wärmeausdehnungen von Leiterpaste und Substrat kompensiert werden, wodurch sich die Zuverlässigkeit der Verbindung zwischen Leiterpaste und Substrat erhöhen lässt, insbesondere bei starker Temperaturwechselbeanspruchung wie beispielsweise im Automobilbereich.

Durch die additive Natur der Siebdrucktechnik, bei der Schichten auf ein Substrat aufgebaut werden, kann zum Metallisieren einer Substrat-Oberfläche darüber hinaus auf den Einsatz von Belichtungs- und Ätz-Verfahren verzichtet werden, was zu Kostenvorteilen des vorgeschlagenen Verfahrens führt.

Eine Dickschichtleiterpaste umfasst üblicherweise zumindest ein Metallpulver als elektrisch leitfähiges Mittel, ein anorganisches Pulver (z.B. Glasfritten) als Anhaftemittel, sowie organische Binde- und Lösemittel. Die organischen Binde- und Lösemittel führen zu einer pastenähnlichen Konsistenz mit bestimmten rheologischen Eigenschaften, die jedoch auch durch die weiteren Bestandteile der Leiterpaste beeinflusst sind.

In Bezug auf den Bestandteil des elektrisch leitfähigen Metallpulvers kann vorzugsweise vorgesehen sein, dass eine Leiterpaste umfassend ein Kupferpulver verwendet wird. Selbstverständlich ist es aber auch möglich, eine Leiterpaste umfassend ein Silber-und/oder Goldpulver zu verwenden. Der Einsatz von Kupferpulver ist dabei jedoch deutlich kostengünstiger.

Bezüglich des Bestandteils des anorganischen Pulvers kann vorzugsweise vorgesehen sein, dass eine Leiterpaste umfassend ein Glas aus dem PbO-B₂O₃-SiO₂-System und/oder ein Glas umfassend Bi₂O₃ verwendet wird. Dadurch kann während des Sinterprozesses im vorgeschlagenen Verfahren trotz der dabei vorherrschenden, verhältnismäßig geringen Brenntemperaturen eine sehr gute Anhaftung der Leiterpaste am Substrat erzielt werden.

Nach dem Aufdrucken einer Leiterpaste, beispielsweise durch ein im Stand der Technik bekanntes Siebdruckverfahren, verbleibt die Leiterpaste aufgrund ihrer rheologischen Eigenschaften im Wesentlichen auf den entsprechenden Bereichen, ohne nennenswert zu verfließen. Um die auf die Oberfläche des Substrats aufgetragene Leiterpaste optimal auf das Brennen bzw. Sintern vorzubereiten, kann vorzugsweise vorgesehen sein, dass die Leiterpaste vor der ersten Brennphase in einer Trocknungsphase bei einer Temperatur von etwa 80 °C bis etwa 200 °C, vorzugsweise von 100 °C bis 150 °C, besonders bevorzugt bei maximal 130 °C, getrocknet wird, vorzugsweise für eine Zeitspanne von etwa 5 min bis etwa 20 min. Durch diese Trocknungsphase lösen sich die in der Leiterpaste vorhandenen Lösemittel im Wesentlichen vollständig auf. Bevorzugt sind dabei bekannte Trocknungsmethoden wie beispielsweise Infrarot- oder Heißlufttrocknung. Durch den Trocknungsprozess und das damit verbundene Auflösen der Lösemittel in der Leiterpaste erfährt die Leiterpaste einen gewissen Volumenschwund. Diesem kann jedoch bereits im Vorfeld durch ein dementsprechend dickeres Auftragen der Leiterpaste entgegengewirkt werden.

Das Brennen bzw. Sintern der Leiterpaste in der ersten und/oder zweiten Brennphase des vorgeschlagenen Verfahrens kann vorzugsweise in einem Brennofen erfolgen, wobei im Brennofen die Brenntemperatur vorherrscht. Selbstverständlich kann bzw. können auch die Trocknungsphase und/oder die Abkühlphase im Brennofen erfolgen. Vorzugsweise kann dabei ein Brennofen mit einer Fördereinrichtung zum Einsatz kommen.

Abhängig von der verwendeten Werkstoffkombination aus Substrat und Leiterpaste kann ein geeignetes Brennprofil angewendet werden. Eine besondere Ausführungsvariante sieht vor, dass in der ersten Brennphase die Brenntemperatur zumindest zeitweise um etwa 40 °C/min bis etwa 60 °C/min erhöht wird. Weiters kann vorgesehen sein, dass in der ersten Brennphase die Brenntemperatur auf eine maximale Brenntemperatur von etwa 580 °C, vorzugsweise etwa 565 °C, besonders bevorzugt etwa 548 °C, erhöht wird.

Eine Erhitzung der Leiterpaste über etwa 400 °C bis 450 °C führt dazu, dass sich alle organischen Inhaltsstoffe, wie beispielsweise organische Bindemittel, im Wesentlichen vollständig auflösen und dass sich die inorganischen Bestandteile (z.B. Glaspulver oder Glasfritten) aufweichen. Darüber hinaus setzt bei diesen Temperaturen der Sinterprozess des Metallpulvers ein. Die aufgeweichten Glasbestandteile der Leiterpaste führen in weiterer Folge zu einer guten Anhaftung der Leiterpaste auf dem Substrat.

Die maximale Brenntemperatur ist grundsätzlich durch die Schmelztemperatur von Aluminium begrenzt, die bei etwa 660 °C liegt. Bei Einsatz einer Leiterpaste auf Silberbasis beträgt die maximale Brenntemperatur vorzugsweise etwa 565 °C und bei Einsatz einer Leiterpaste auf Kupferbasis beträgt die maximale Brenntemperatur vorzugsweise etwa 548 °C. Diese Temperaturen ergeben sich aus den Schmelztemperaturen von möglichen dabei entstehenden eutektischen Aluminium-Kupfer bzw. Aluminium-Silber Legierungen.

In Bezug auf die jeweilige maximale Brenntemperatur sind für eine Leiterpaste geeignete Glasbestandteile auszuwählen, deren entsprechende Glasübergangstemperatur (T_{G}) bzw. Schmelztemperatur (T_{S}) an diese maximale Brenntemperatur angepasst sind. Die Glasübergangstemperatur bzw. Schmelztemperatur des Glasbestandteils der entsprechenden Leiterpaste sollte demnach entsprechend unterhalb der angegebenen maximalen Brenntemperaturen liegen, um eine optimale Anhaftung der Leiterpaste auf dem Substrat zu gewährleisten. Geeignet sind insbesondere Gläser aus dem PbO-B₂O₃-SiO₂-System oder Gläser umfassend Bi₂O₃.

Als besonders vorteilhaft hat es sich herausgestellt, wenn das Brennen der Leiterpaste in der zweiten Brennphase für etwa 5 min bis etwa 30 min erfolgt. Dadurch kann eine optimale Anhaftung der Leiterpaste auf dem Substrat erzielt werden. Grundsätzlich gilt, je länger die Zeitspanne in der zweiten Brennphase ist (bei maximaler Brenntemperatur), desto dichter sintert die Leiterpaste und weist somit bessere Eigenschaften für die Weiterverarbeitung (z.B. Löten und Schweißen) auf. Bei zu langen Zeitspannen in der zweiten Brennphase wird jedoch die Durchlaufzeit in einem typischen Einbrennofen entsprechend verlängert, was sich negativ auf den Gesamtdurchsatz auswirken kann.

In einer weiteren vorteilhaften Ausführungsvariante kann vorgesehen sein, dass in der zweiten Brennphase die vorgebbare maximale Brenntemperatur im Wesentlichen konstant gehalten wird.

Vorzugsweise kann außerdem vorgesehen sein, dass die Leiterpaste in der ersten Brennphase und/oder der zweiten Brennphase einer Schutzgasatmosphäre umfassend Stickstoff ausgesetzt wird. Durch den Einsatz eines inerten Gases bzw. Schutzgases kann eine Oxidation eines beispielsweise in der Leiterpaste enthaltenen Kupfers verringert bzw. verhindert werden. Dies ist insbesondere bei hohen Temperaturen vorteilhaft. Eine Schutzgasatmosphäre (z.B. Stickstoff) ist für den Einbrand von Kupfer-Leiterbahnpasten vorteilhaft, um die Oxidation des Leiterbahnmaterials zu unterbinden (es kann abhängig von der Brennphase ein Restsauerstoffgehalt von einigen ppm vorliegen). Die organischen Binder eines solchen Materials bzw. der Leiterpaste können dabei so konzipiert sein, dass sie unter einer Stickstoffatmosphäre reduziert werden können. Für Silber-Leiterbahnpasten kann wiederum eine herkömmliche LuftAtmosphäre vorteilhaft sein, weil es hierbei zu keiner nennenswerten Beeinträchtigung der Leiterbahnoberfläche durch Oxidation kommt. Die hierbei eingesetzten organischen Binder können über den Luftsauerstoff oxidiert werden.

In einer bevorzugten Ausführungsform der Erfindung kann vorgesehen sein, dass in der Abkühlphase die Brenntemperatur zumindest zeitweise um etwa 20 °C/min bis etwa 40 °C/min, vorzugsweise um etwa 30 °C/min, reduziert wird. Vorzugsweise erfolgt dabei das Abkühlen bis auf Umgebungstemperatur. Je langsamer die Abkühlung erfolgt, desto geringer sind die mechanischen Auswirkungen der Verbindung zwischen Leiterpaste und Substrat aufgrund unterschiedlicher Wärmeausdehnungskoeffizienten der verwendeten Werkstoffe.

Durch die typische Oxidation der gesinterten Leiterpaste, die während des Brenn- bzw. Sinterprozesses durch die dabei vorherrschenden hohen Temperaturen erfolgt, ist vorgesehen, dass die Oberfläche der Leiterpaste nach der Abkühlung entsprechend mechanisch nachbehandelt wird, um die weitere Verarbeitung zu erleichtern, beispielsweise für nachfolgende Löt- oder Schweißverfahren.

Gemäß einer bevorzugten Ausführungsform kann vorgesehen sein, dass die Leiterpaste mit einer Dicke von etwa 10 µm bis etwa 100 µm auf die Oberfläche des Substrats aufgebracht wird. Selbstverständlich ist es auch möglich, Leiterpasten mit einer Dicke von weniger als 10 µm oder Leiterpasten mit einer Dicke von mehr als 100 µm auf die Oberfläche des Substrats aufzubringen. Es kann auch vorgesehen sein, dass das vorgeschlagene Verfahren mehrmals hintereinander angewendet wird, um die sich insgesamt ergebende Dicke der Leiterpaste zu erhöhen. Vorzugsweise weist die wenigstens eine Leiterfläche der vorgeschlagenen Leiterplatte, die der gesinterten Leiterpaste entsprechen kann, eine Dicke von 25 µm bis 125 µm, vorzugsweise von 90 µm bis 110 µm, auf.

Weitere Einzelheiten und Vorteile der vorliegenden Erfindung werden anhand der nachfolgenden Figurenbeschreibung erläutert. Dabei zeigt bzw. zeigen:
- Fig. 1: ein Schaltbild eines als Wechselrichter ausgebildeten Leistungselektronikmoduls,
- Fig. 2a: eine perspektivische Ansicht einer vorgeschlagenen Leiterplatte,
- Fig. 2b: die Leiterplatte der Fig. 2a mit daran angeordneten elektronischen Bauelementen,
- Fig. 3: eine weitere vorgeschlagene Leiterplatte mit darauf angeordneten elektronischen Bauteilen,
- Fig. 4: ein Ausführungsbeispiel eines vorgeschlagenen Leistungselektronikmoduls während der Assemblierung,
- Fig. 5: ein vorgeschlagenes Leistungselektronikmodul in perspektivischer Ansicht,
- Fig. 6: ein Leistungselektronikmodul gemäß Fig. 5 in einer Seitenansicht,
- Fig. 7a: eine Schnittdarstellung gemäß Schnittlinie I-I der Fig. 5,
- Fig. 7b: eine Detaildarstellung der Fig. 7a,
- Fig. 8a: eine Schnittdarstellung gemäß Schnittlinie II-II der Fig. 5 und
- Fig. 8b: eine Detaildarstellung der Fig. 8a.

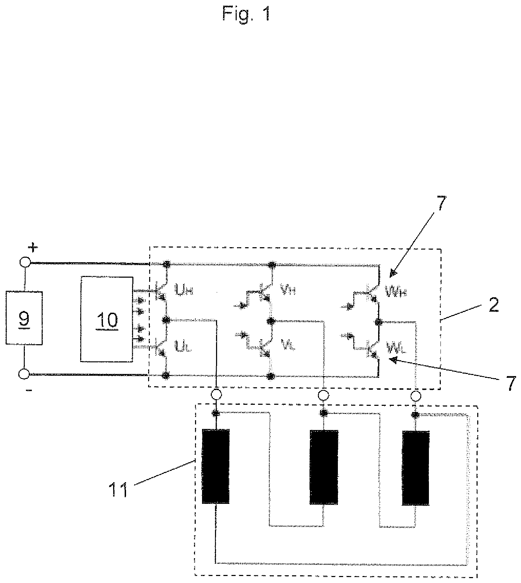

Fig. 1 zeigt ein Blockschaltbild eines als Wechselrichter ausgebildeten Leistungselektronikmoduls 2. Das Leistungselektronikmodul 2 umfasst sechs als IGBTs U_{H}, V_{H}, W_{H}, U_{L}, V_{L}, W_{L} ausgebildete elektronische Bauteile 7 und ist an eine Gleichspannungsquelle 9 angeschlossen, beispielsweise an eine Batterie. Durch eine Ansteuerelektronik 10 werden die Gateanschlüsse der drei Highside-Transistoren U_{H}, V_{H}, W_{H} und der drei Lowside-Transistoren U_{L}, V_{L}, W_{L} in bekannter Art und Weise angesteuert, sodass die Gleichspannung der Gleichspannungsquelle 9 durch das Leistungselektronikmodul 2 in drei phasenverschobene Wechselspannungen umgerichtet und einem Drehstrommotor 11 zugeführt wird. Jeder der sechs IGBTs kann zusätzlich jeweils mit einer korrespondierenden Freilaufdiode verschaltet sein. Aus Gründen der Übersichtlichkeit sind diese Freilaufdioden in dieser Darstellung jedoch nicht gezeigt.

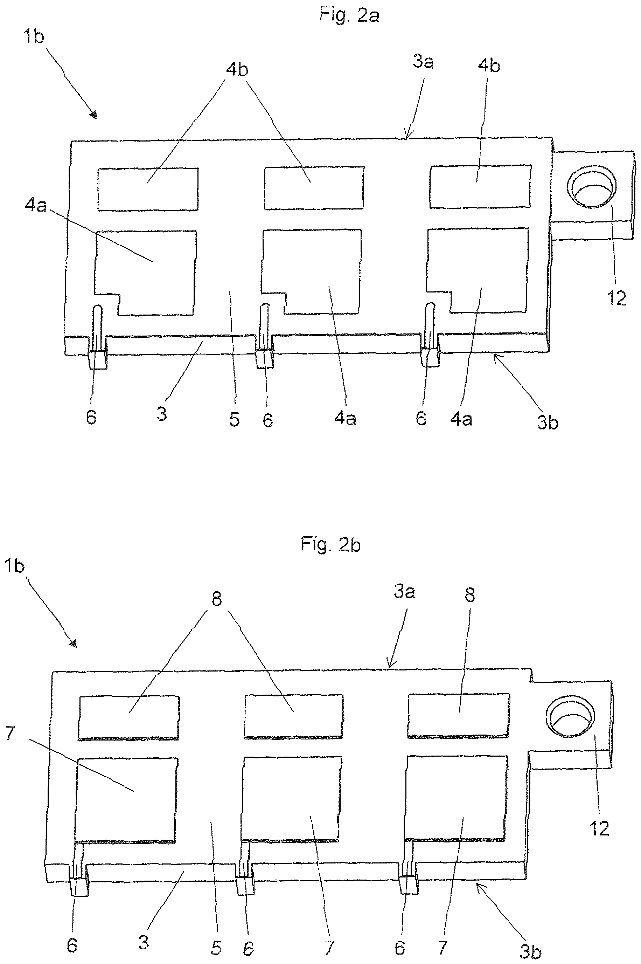

Fig. 2a zeigt eine Leiterplatte 1b eines als Wechselrichter ausgebildeten Leistungselektronikmoduls 2 gemäß Fig. 1. Die Leiterplatte 1b umfasst ein elektrisch leitfähiges Substrat 3 in Form einer Aluminiumplatte, deren Oberflächen 3a, 3b im Wesentlichen eben ausgebildet sind. Bei der Leiterplatte 1b kann es sich beispielsweise um die positive Stromschiene des Wechselrichters handeln, die mittels Anschlusselement 12 mit dem positiven Pol einer Gleichspannungsquelle 9 zu verbinden ist. Die Oberfläche 3a der Leiterplatte 1b weist drei Leiterflächen 4a für darauf anzuordnende IGBTs sowie drei Leiterflächen 4b für darauf anzuordnende Freilaufdioden auf. Die Leiterflächen 4a, 4b sind von einer Isolatorfläche 5 umgeben bzw. umrahmt. Sowohl Leiterflächen 4a, 4b als auch Isolatorfläche 5 können in Form von entsprechenden Dickschichtpasten mittels Siebdrucktechnik auf die Oberfläche 3a des Substrats 3 aufgebracht und bspw. in einem Brennofen gebrannt bzw. gesintert werden. Um die Gateanschlüsse der IGBTs mit entsprechenden Steuersignalen versorgen zu können, sind zusätzlich auf der Isolatorfläche 5 entsprechenden Anschlussflächen 6 angeordnet.

Fig. 2b zeigt die Leiterplatte 1b der Fig. 2a mit auf den Leiterflächen 4a angeordneten IGBTs 7 und mit auf den Leiterflächen 4b angeordneten Freilaufdioden 8. Die Gateanschlüsse der IGBTs 7 sind dabei mit den Anschlussflächen 6 verbunden.

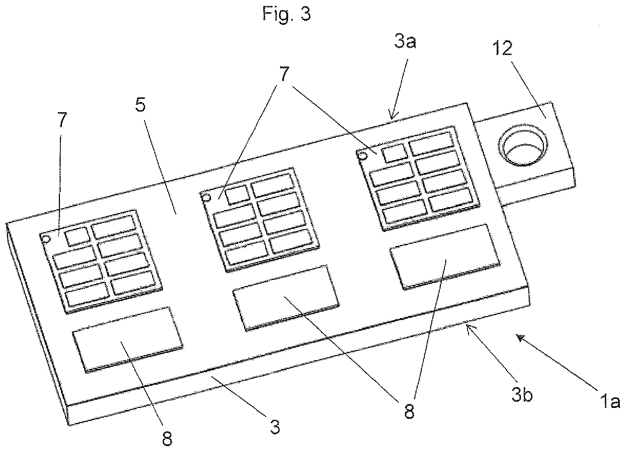

Fig. 3 zeigt eine weitere Leiterplatte 1a ähnlich jener der Fig. 2a - jedoch ohne Gateanschlüsse bzw. Anschlussflächen 6 - mit auf den Leiterflächen 4a angeordneten IGBTs 7 und mit auf den Leiterflächen 4b angeordneten Freilaufdioden 8. Die elektronischen Bauteile 7, 8 sind dabei bspw. mittels Dampfphasenlöten an die entsprechenden Leiterflächen 4a, 4b angelötet worden.

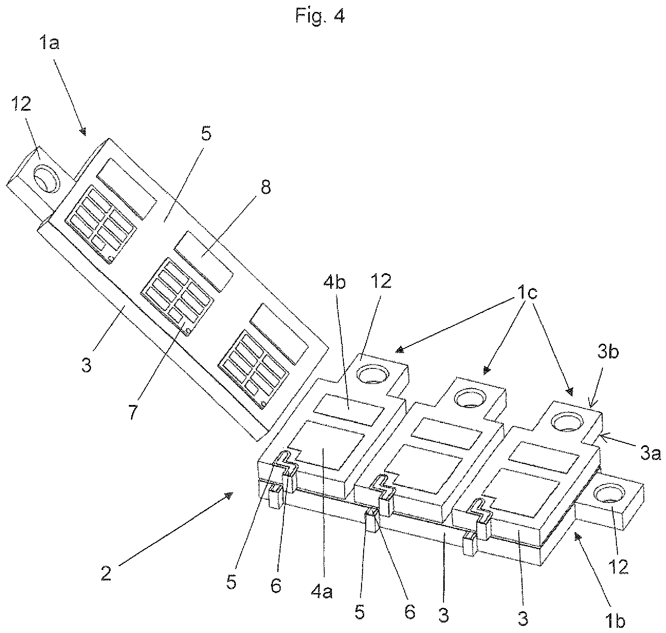

Fig. 4 zeigt ein Ausführungsbeispiel eines Leistungselektronikmoduls 2 nach Fig. 1, wobei das Leistungselektronikmodul 2 eine erste Leiterplatte 1a, eine zweite Leiterplatte 1b sowie drei dritte Leiterplatten 1c umfasst. Die erste Leiterplatte 1a entspricht dabei der Leiterplatte 1a gemäß Fig. 3 und die zweite Leiterplatte 1b entspricht dabei der Leiterplatte 1b gemäß Fig. 2a. Mittels Anschlusselement 12 des Substrats 3 der ersten Leiterplatte 1a kann die erste Leiterplatte 1a beispielsweise an den negativen Pol einer Gleichspannungsquelle 9 angeschlossen werden, wodurch das Substrat 3 der ersten Leiterplatte 1a als negative Stromschiene ausgeführt ist. Die zweite Leiterplatte 1b kann mittels Anschlusselement 12 ihres Substrats 3 beispielsweise an den positiven Pol einer Gleichspannungsquelle 9 angeschlossen werden, wodurch das Substrat 3 der zweiten Leiterplatte 1b als positive Stromschiene ausgeführt ist.

Die drei dritten Leiterplatten 1c umfassen jeweils ein elektrisch leitfähiges Substrat 3 in Form einer Aluminiumplatte, deren Oberflächen 3a, 3b im Wesentlichen eben ausgebildet sind. An jeder ersten Oberfläche 3a des Substrats 3 einer dritten Leiterplatte 1c sind jeweils eine elektrisch leitfähige Leiterfläche 4a für einen damit zu verbindenden IGBT sowie eine elektrisch leitfähige Leiterfläche 4b für eine damit zu verbindende Freilaufdiode angeordnet. Auf jeder der zweiten Oberflächen 3b eines Substrats 3 einer dritten Leiterplatte 1c ist zusätzlich zu den elektrisch leitfähigen Leiterflächen 4a, 4b entsprechend der jeweils ersten Oberfläche 3a eine Isolatorfläche 5 angeordnet, auf der zur Kontaktierung einer Gateelektrode eines IGBTs eine elektrisch leitfähige Anschlussfläche 6 angeordnet ist. Jedes Substrat 3 der drei dritten Leiterplatten 1c weist ein Anschlusselement 12 auf, mit dem jede der drei dritten Leiterplatten 1c mit einer Phase eines Drehstrommotors 11 zu verbinden ist.

Wie in Fig. 4 dargestellt, werden zur Assemblierung des Leistungselektronikmoduls 2 die Leiterplatten 1a, 1b, 1c derart vertikal übereinander gestapelt, dass die drei dritten Leiterplatten 1c nebeneinander liegend zwischen der ersten Leiterplatte 1a und der zweiten Leiterplatte 1b angeordnet werden. Zwischen erster Leiterplatte 1a und den drei dritten Leiterplatten 1c befinden sich drei IGBTs 7 und drei Freilaufdioden 8, die an den jeweiligen Leiterflächen 4a, 4b der Leiterplatten 1a, 1c angelötet werden können. Ebenso befinden sich zwischen den drei dritten Leiterplatten 1c und der zweiten Leiterplatte 1b wiederum drei IGBTs 7 und drei Freilaufdioden 8, die an den entsprechenden Leiterflächen 4a, 4b der ersten Oberflächen 3a der dritten Leiterplatten 1c und der ersten Oberfläche 3a der zweiten Leiterplatte 1b angelötet werden können. Die Gateanschlüsse der drei IGBTs 7 zwischen der ersten Leiterplatte 1a und den drei dritten Leiterplatten 1c können über die Anschlussflächen 6 an den zweiten Oberflächen 3b der dritten Leiterplatten 1c kontaktiert werden und die Gateanschlüsse der IGBTs 7 zwischen den drei dritten Leiterplatten 1c und der zweiten Leiterplatte 1b können über die Anschlussflächen 6 der ersten Oberfläche 3a der zweiten Leiterplatte 1b kontaktiert werden.

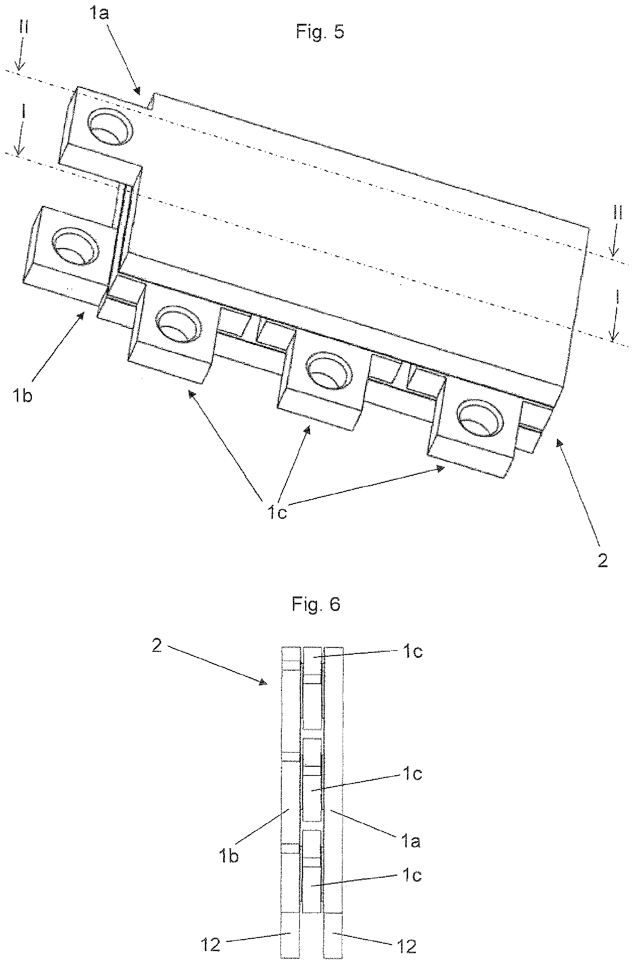

Fig. 5 zeigt ein fertig assembliertes Leistungselektronikmodul 2 gemäß Fig. 4 mit dem Unterschied, dass jeweils auf beiden Oberflächen 3a, 3b der drei dritten Leiterplatten 1c eine Isolatorfläche 5 in Form einer durch ein Siebdruckverfahren aufgebrachten dielektrischen Schicht angeordnet ist, wobei die jeweilige Isolatorfläche 5 einer Oberfläche 3a, 3b die jeweiligen Leiterflächen 4a, 4b umgibt. Hier ist insbesondere auch die vertikale Stapelung der Leiterplatten 1a, 1b, 1c und die damit gewonnene kompakte Bauform des Leistungselektronikmoduls 2 ersichtlich.

Fig. 6 zeigt das Leistungselektronikmodul 2 der Fig. 5 in einer Seitenansicht. Die Anschlusselemente 12 der Substrate 3 der Leiterplatten 1a, 1b, 1c bilden dabei die Anschlusspunkte an weitere Bauelemente (vgl. Fig. 1). Das Anschlusselement 12 der ersten Leiterplatte 1a kann dabei mit dem negativen Pol und das Anschlusselement 12 der zweiten Leiterplatte 1b kann mit dem positiven Pol einer Gleichspannungsquelle 9 verbunden werden. Die Anschlusselemente 12 der drei dritten Leiterplatten 1c können mit den entsprechenden Phasenanschlüssen eines Drehstrommotors 11 verbunden werden.

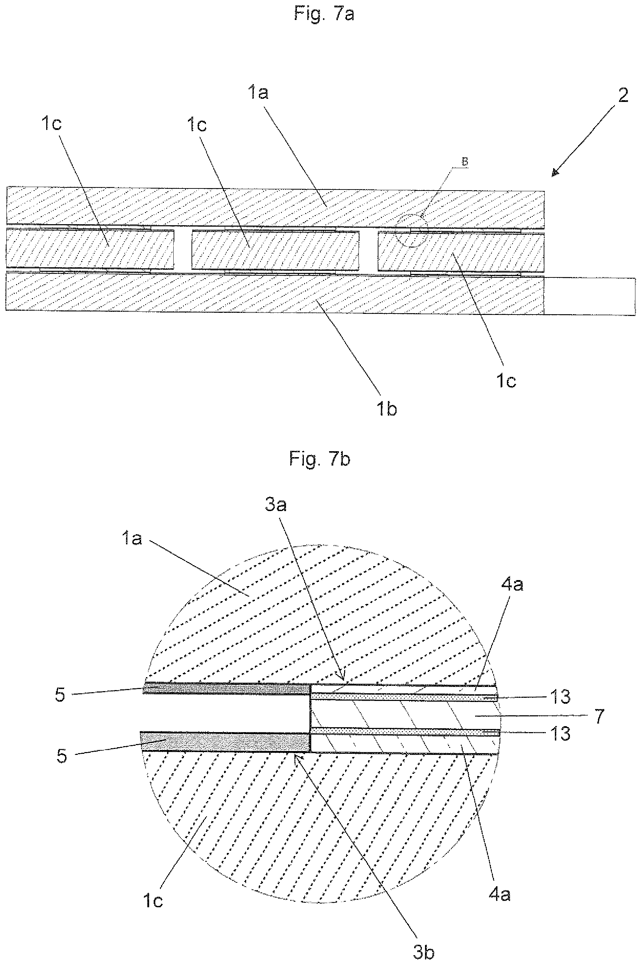

Fig. 7a zeigt eine Schnittdarstellung des Leistungselektronikmoduls 2 der Fig. 5 gemäß der Schnittlinie I-I und Fig. 7b zeigt den mit einem Kreis markierten Bereich B der Fig. 7a in einer vergrößerten Darstellung. Die vergrößerte Darstellung der Fig. 7b zeigt einen IGBT 7, der zwischen der ersten Leiterplatte 1a und einer der drei dritten Leiterplatten 1c des Leistungselektronikmoduls 2 angeordnet ist. Der IGBT 7 ist dabei sowohl auf der Leiterfläche 4a an der Oberfläche 3a der ersten Leiterplatte 1a als auch auf der Leiterfläche 4a an der Oberfläche 3b der dritten Leiterplatte 1c angelötet, z.B. mittels Dampfphasenlöten. Mit dem Bezugszeichen 13 ist jeweils das dabei verwendete Lot angedeutet. Die Leiterflächen 4a und auch die hier nicht sichtbaren Leiterflächen 4b auf der Oberfläche 3a der ersten Leiterplatte 1a und auf der Oberfläche 3b der dritten Leiterplatte 1c sind von einer dielektrischen Isolatorfläche 5 umgeben.

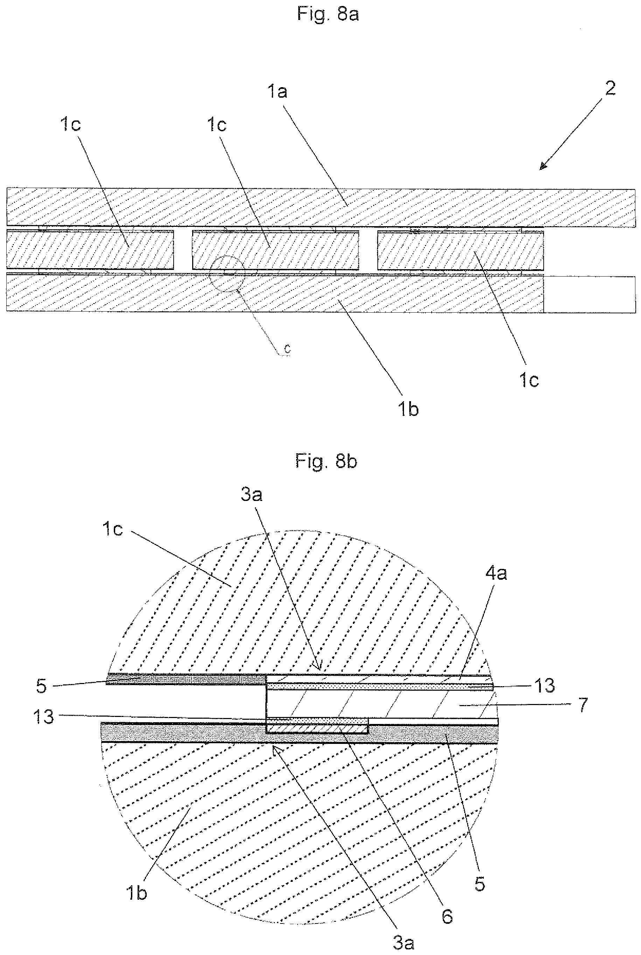

Fig. 8a zeigt eine Schnittdarstellung des Leistungselektronikmoduls 2 der Fig. 5 gemäß der Schnittlinie II-II und Fig. 8b zeigt den mit einem Kreis markierten Bereich C der Fig. 8a in einer vergrößerten Darstellung. Im Vergleich zur Detaildarstellung gemäß Fig. 7b ist in der vergrößerte Darstellung der Fig. 8b ein IGBT 7 zu sehen, der zwischen der zweiten Leiterplatte 1b und einer der drei dritten Leiterplatten 1c des Leistungselektronikmoduls 2 angeordnet ist. Die Leiterflächen 4a, 4b auf der Oberfläche 3a der zweiten Leiterplatte 1b und auf der Oberfläche 3a der dritten Leiterplatte 1c sind von einer dielektrischen Isolatorfläche 5 umgeben. Der gezeigte Schnitt gemäß der Schnittlinie II-II der Fig. 5 befindet sich im Bereich des Gateanschlusses des IGBTs 7. Um das Gate des IGBTs 7 elektrisch ansteuern zu können, ist auf der Isolatorfläche 5 auf der Oberfläche 3a der zweiten Leiterplatte 1b eine Anschlussfläche 6 in Form einer elektrisch leitfähigen Schicht angeordnet. Mit dem Bezugszeichen 13 ist wiederum jeweils das Lot angedeutet, das zum Anlöten des IGBTs 7 an der Leiterfläche 4a der dritten Leiterplatte 1c und an der Anschlussfläche 6 der zweiten Leiterplatte 1b zum Einsatz gekommen ist.

Bei einem vorgeschlagenen Leistungselektronikmodul 2 mit vorgeschlagenen Leiterplatten 1a, 1b, 1c können elektronische Bauteile 7, 8 durch das Vorsehen von lötbaren elektrisch leitfähigen Leiterflächen 4a, 4b direkt auf die Substrate 3 der Leiterplatten 1a, 1b, 1c aufgelötet werden. Dadurch kann auf andere übliche Verbindungstechniken, wie bspw. Drahtbonden, verzichtet werden. Durch das zusätzliche Anbringen einer Isolatorfläche 5 ist es möglich, die Leiterplatten 1a, 1b, 1c sehr kompakt anzuordnen, z.B. vertikal zu stapeln, ohne dabei Spannungsfestigkeit einzubüßen. Bei einer gestapelten Bauform kann somit der Abstand zwischen zwei strom- bzw. spannungsführenden Substraten 3 von Leiterplatten 1a, 1b, 1c auf die Dicke der elektronischen Bauteile 7, 8 (z.B. 250 µm eines herkömmlichen IGBTs 7) sowie die Dicke der Leiterflächen 4a, 4b (z.B. 100 µm) reduziert werden. Bei einem als Wechselrichter ausgebildeten Leistungselektronikmodul 2 kann durch einen reduzierten Abstand zwischen den Highside-Transistoren und den Lowside-Transistoren darüber hinaus eine reduzierte Induktivität des Leistungselektronikmoduls 2 erreicht werden und somit die Effizienz des Leistungselektronikmoduls 2 erhöht werden.

Bei der Herstellung eines Leistungselektronikmoduls kann vorgesehen sein, dass die Leiterflächen 4a, 4b und die Anschlussflächen 6 einer Leiterplatte 1a, 1b, 1c jeweils gemeinsam gebrannt bzw. gesintert werden.

In einer besonders bevorzugten Ausführungsform kann vorgesehen sein, dass das gesamte, vorzugsweise gestapelte Leistungselektronikmodul 2 in einem Arbeitsschritt fertig gestellt wird, indem die zwischen den jeweiligen Leiterplatten 1a, 1b, 1c angeordneten Bauteile 7, 8 (vgl. Fig. 4) in einem Arbeitsschritt an die jeweiligen Leiterflächen 4a, 4b und Anschlussflächen 6 angelötet werden (z.B. durch Dampfphasenlöten). Selbstverständlich kann auch vorgesehen sein, die Assemblierung der Leiterplatten 1a, 1b, 1c in mehreren Schritten durchzuführen. Beispielsweise können die elektronischen Bauteile 7, 8 jeweils an die erste Leiterplatte 1a und die zweite Leiterplatte 1b angelötet werden und in einem weiteren Schritt die elektronischen Bauteile 7, 8 an den entsprechenden Leiterflächen 4a, 4b und Anschlussflächen 6 der dritten Leiterplatten 1c angelötet werden. Dabei können die Isolatorflächen 5 der Leiterplatten 1a, 1b, 1c auch als Lötstoppmasken agieren, welche die elektronischen Bauteile 7, 8 während eines Lötvorgangs in den gewünschten Positionen halten.

Eine auf den Leiterflächen 4a, 4b anzuordnende Lötpaste kann generell auch dazu verwendet werden, die Substrate 3 der Leiterplatten 1a, 1b, 1c besser aneinander auszurichten, indem bspw. unterschiedlich dicke Schichten von Lötpasten auf die Leiterflächen 4a, 4b aufgetragen werden. Generell können anstatt von Lötpaste auch Lötformteile eingesetzt werden.

Zum Löten können auch Lote mit unterschiedlichen Schmelzpunkten verwendet werden. So können beispielsweise ein SnAgCu-Lot mit einer Liquidustemperatur von etwa 220 °C und ein Hochblei-Lot mit einer Liquidustemperatur von etwa 300 °C eingesetzt werden. Dadurch können z.B. zunächst die elektronischen Bauteile mit ihren ersten Seiten mit dem Hochblei-Lot auf den Leiterflächen eines Substrats angelötet und fixiert werden und in einem weiteren Schritt die elektronischen Bauteile mit ihren zweiten Seiten mit dem SnAgCu-Lot auf den Leiterflächen eines weiteren Substrats angelötet werden. Es können damit also die Bauteile zuverlässig in Position gehalten werden.

Mit der vorgeschlagenen Leiterplatte kann generell ein Substrat bereit gestellt werden, weiches zusätzlich zu einer Wärmeabführfunktion auch die Funktion eines elektrischen Leiters übernimmt. Durch das Anbringen von elektrisch leitfähigen Leiterflächen und dielektrischen Isolatorflächen auf dem Substrat einer vorgeschlagenen Leiterplatte können einerseits elektronische Bauteile leicht an das Substrat angelötet und damit elektrisch kontaktiert werden und andererseits kompakte Bauformen von Leistungselektronikmodulen, bspw. durch vertikale Stapelung, erzielt werden. Durch die Isolatorflächen können Abstände von spannungsführenden Teilen reduziert und damit die Induktivität eines Leistungselektronikmoduls reduziert werden. Durch den Einsatz von Aluminium als Material für die Substrate kann darüber hinaus eine direkte, zweiseitige Kühlung eines Leistungselektronikmoduls erzielt werden, was höhere Stromdichten ermöglicht. Durch das Vorsehen von Lötverbindungen kann auf andere Verbindungstechniken wie Drahtbonden verzichtet werden, wodurch sich die Zuverlässigkeit von Bauteilverbindungen erhöhen lässt. Bei Verwendung von Dickschichttechnik zur Herstellung von Leiterflächen auf dem Substrat einer vorgeschlagenen Leiterplatte kann darüber hinaus durch die dadurch ermöglichte direkte Bauteilassemblierung auf dem Substrat der thermische Widerstand zwischen einem auf dem Substrat angeordneten elektronischen Bauteil und dem als Kühlkörper agierenden Substrat verringert werden. Durch die hohe Porosität einer bei verhältnismäßig geringen Temperaturen gesinterten Kupferleiterpaste kann darüber hinaus die mechanische Beanspruchung in einer Lötschicht zwischen einer Leiterfläche und einem darauf angeordneten elektronischen Bauteil reduziert werden. Dies führt insbesondere zu einer höheren Temperaturzyklenfestigkeit sowie zu einer erhöhten Lebensdauer.

## Patentansprüche

1. Leiterplatte (1a, 1b, 1c), insbesondere für ein Leistungselektronikmodul (2), umfassend ein elektrisch leitfähiges Substrat (3) mit einem Anschlusselement (12) zum Anschließen der Leiterplatte (1a, 1b, 1c) an eine Gleichspannungsquelle oder an einen Drehstrommotor, wobei das Substrat (3) zumindest teilweise, vorzugsweise vollständig, aus Aluminium und/oder einer Aluminiumlegierung besteht, **dadurch gekennzeichnet, dass** auf wenigstens einer Oberfläche (3a, 3b) des elektrisch leitfähigen Substrats (3) wenigstens eine Leiterfläche (4a, 4b) in Form einer, vorzugsweise durch ein Druckverfahren, besonders bevorzugt durch ein Siebdruckverfahren, aufgebrachten, elektrisch leitfähigen Schicht angeordnet ist, wobei die Leiterfläche (4a, 4b) direkt mit dem elektrisch leitfähigen Substrat (3) elektrisch kontaktiert ist.

2. Leiterplatte nach Anspruch 1, **dadurch gekennzeichnet, dass** die wenigstens eine Oberfläche (3a, 3b) des elektrisch leitfähigen Substrats (3) im Wesentlichen eben ausgebildet ist.

3. Leiterplatte nach Anspruch 1 oder 2, **dadurch gekennzeichnet, dass** die Leiterfläche (4a, 4b) im Wesentlichen aus Kupfer besteht.

4. Leiterplatte nach einem der Ansprüche 1 bis 3, **dadurch gekennzeichnet, dass** die Leiterfläche (4a, 4b) ein Glas aus dem PbO-B₂O₃-SiO₂-System und/oder ein Glas umfassend Bi₂O₃ umfasst.

5. Leiterplatte nach einem der Ansprüche 1 bis 4, **dadurch gekennzeichnet, dass** die Leiterfläche (4a, 4b) eine Dicke von 25 µm bis 125 µm, vorzugsweise von 90 µm bis 110 µm, aufweist.

6. Leiterplatte nach einem der Ansprüche 1 bis 5, **dadurch gekennzeichnet, dass** auf der wenigstens einen Oberfläche (3a, 3b) des elektrisch leitfähigen Substrats (3) wenigstens eine Isolatorfläche (5) in Form einer, vorzugsweise durch ein Druckverfahren - besonders bevorzugt durch ein Siebdruckverfahren - aufgebrachten, dielektrischen Schicht angeordnet ist, wobei vorzugsweise die wenigstens eine Isolatorfläche (5) zumindest teilweise an der wenigstens einen Leiterfläche (4a, 4b) angrenzt, vorzugsweise die wenigstens eine Leiterfläche (4a, 4b) umgibt.

7. Leiterplatte nach Anspruch 6, **dadurch gekennzeichnet, dass** auf der wenigstens einen Isolatorfläche (5) wenigstens eine Anschlussfläche (6) in Form einer elektrisch leitfähigen Schicht angeordnet ist.

8. Leiterplatte nach einem der Ansprüche 1 bis 7, **dadurch gekennzeichnet, dass** auf der wenigstens einen Oberfläche (3a, 3b) des elektrisch leitfähigen Substrats (3) eine Mehrzahl von Leiterflächen (4a, 4b), vorzugsweise sechs Leiterflächen (4a, 4b), angeordnet sind, wobei vorzugsweise die Leiterflächen (4a, 4b) von einer Isolatorfläche (5) umgeben sind.

9. Leiterplatte nach Anspruch 8, **dadurch gekennzeichnet, dass** auf der Isolatorfläche (5) eine Mehrzahl von Anschlussflächen (6), vorzugsweise drei Anschlussflächen (6), angeordnet sind.

10. Leiterplatte nach einem der Ansprüche 1 bis 7, **dadurch gekennzeichnet, dass** auf einer ersten Oberfläche (3a) des elektrisch leitfähigen Substrats (3) eine Mehrzahl von Leiterflächen (4a, 4b), vorzugsweise zwei Leiterflächen (4a, 4b), angeordnet sind und dass auf einer zweiten Oberfläche (3b) des elektrisch leitfähigen Substrats (3) eine Mehrzahl von Leiterflächen (4a, 4b), vorzugsweise zwei Leiterflächen (4a, 4b), sowie wenigstens eine Isolatorfläche (5) angeordnet sind, wobei auf der wenigstens einen Isolatorfläche (5) eine Anschlussfläche (6) angeordnet ist.

11. Leistungselektronikmodul (2) umfassend wenigstens eine Leiterplatte (1a, 1b, 1c) nach einem der Ansprüche 1 bis 10.

12. Leistungselektronikmodul nach Anspruch 11, **dadurch gekennzeichnet, dass** das Leistungselektronikmodul (2) eine erste Leiterplatte (1a) nach Anspruch 8, eine zweite Leiterplatte (1b) nach Anspruch 9 und drei dritte Leiterplatten (1c) nach Anspruch 10 umfasst.

13. Leistungselektronikmodul nach Anspruch 12, **dadurch gekennzeichnet, dass** die Leiterplatten (1a, 1b, 1c) im Wesentlichen gestapelt angeordnet sind, wobei die drei dritten Leiterplatten (1c), vorzugsweise nebeneinander liegend, zwischen der ersten Leiterplatte (1a) und der zweiten Leiterplatte (1b) angeordnet sind.

14. Leistungselektronikmodul nach Anspruch 12 oder 13, **dadurch gekennzeichnet, dass** das Leistungselektronikmodul (2) als Hochstrom-Mehrphasen-Leistungsbrücke ausgebildet ist, wobei auf der wenigstens einen Oberfläche (3a) der ersten Leiterplatte (1a) und/oder den zweiten Oberflächen (3b) der drei dritten Leiterplatten (1c) drei Transistoren, vorzugsweise IGBTs, und drei Freilaufdioden angebracht, vorzugsweise angelötet, sind und wobei auf der wenigstens einen Oberfläche (3a) der zweiten Leiterplatte (1b) und/oder den ersten Oberflächen (3a) der drei dritten Leiterplatten (1c) drei Transistoren, vorzugsweise IGBTs, und drei Freilaufdioden angebracht, vorzugsweise angelötet, sind.

15. Verfahren zur Herstellung einer Leiterplatte (1a, 1b, 1c) nach einem der Ansprüche 1 bis 10, **dadurch gekennzeichnet, dass** auf einer Oberfläche (3a, 3b) des Substrats (3) zumindest bereichsweise eine Leiterpaste aufgebracht wird, in einer ersten Brennphase die Leiterpaste einer im Wesentlichen kontinuierlich steigenden Brenntemperatur ausgesetzt wird, wobei die Brenntemperatur auf eine vorgebbare maximale Brenntemperatur kleiner etwa 660 °C erhöht wird, in einer zweiten Brennphase die Leiterpaste für einen vorgebbaren Zeitraum im Wesentlichen der vorgebbaren maximalen Brenntemperatur ausgesetzt wird, in einer Abkühlphase die Leiterpaste abgekühlt wird und in einer Nachbehandlungsphase eine Oberfläche der Leiterpaste mechanisch nachbehandelt, vorzugsweise gebürstet, wird.

## Claims

1. A printed circuit board (1a, 1b, 1c), in particular for a power electronic module (2), comprising an electrically conductive substrate (3) with a connecting element (12) for connecting the printed circuit board (1a, 1b, 1c) to a dc voltage source or a three-phase motor, wherein the substrate (3) at least partially, preferably completely, comprises aluminum and/or an aluminum alloy, **characterised in that** arranged on at least one surface (3a, 3b) of the electrically conductive substrate (3) is at least one conductor surface (4a, 4b) in the form of an electrically conductive layer applied preferably by a printing process and particularly preferably by a screen printing process, wherein the conductor surface (4a, 4b) is directly electrically contacted with the electrically conductive substrate (3).

2. A printed circuit board as set forth in claim 1 **characterised in that** the at least one surface (3a, 3b) of the electrically conductive substrate (3) is substantially flat.

3. A printed circuit board as set forth in claim 1 or 2 **characterised in that** the conductor surface (4a, 4b) substantially comprises copper.

4. A printed circuit board as set forth in one of claims 1 through 3 **characterised in that** the conductor surface (4a, 4b) includes a glass from the PbO-B₂O₃-SiO₂ system and/or a glass including Bi₂O₃.

5. A printed circuit board as set forth in one of claims 1 through 4 **characterised in that** the conductor surface (4a, 4b) is of a thickness of between 25 µm and 125 µm, preferably between 90 µm and 110 µm.

6. A printed circuit board as set forth in one of claims 1 through 5 **characterised in that** arranged on the at least one surface (3a, 3b) of the electrically conductive substrate (3) is at least one insulator surface (5) in the form of a dielectric layer preferably applied by a printing process and particularly preferably by a screen printing process, wherein preferably the at least one insulator surface (5) at least partially adjoins the at least one conductor surface (4a, 4b) and preferably surrounds the at least one conductor surface (4a, 4b).

7. A printed circuit board as set forth in claim 6 **characterised in that** at least one connecting surface (6) in the form of an electrically conductive layer is arranged on the at least one insulator surface (5).

8. A printed circuit board as set forth in one of claims 1 through 7 **characterised in that** a plurality of conductor surfaces (4a, 4b), preferably six conductor surfaces (4a, 4b), are arranged on the at least one surface (3, 3b) of the electrically conductive substrate (3), wherein preferably the conductor surfaces (4a, 4b) are surrounded by an insulator surface (5).

9. A printed circuit board as set forth in claim 8 **characterised in that** a plurality of connecting surfaces (6), preferably three connecting surfaces (6), are arranged on the insulator surface (5).

10. A printed circuit board as set forth in one of claims 1 through 7 **characterised in that** a plurality of conductor surfaces (4a, 4b), preferably two conductor surfaces (4a, 4b), are arranged on a first surface (3a) of the electrically conductive substrate (3), and that a plurality of conductor surfaces (4a, 4b), preferably two conductor surfaces (4a, 4b), and at least one insulator surface (5) are arranged on a second surface (3b) of the electrically conductive substrate (3), wherein a connecting surface (6) is arranged on the at least one insulator surface (5).

11. A power electronic module (2) comprising at least one printed circuit board (1a, 1b, 1c) as set forth in one of claims 1 through 10.

12. A power electronic module as set forth in claim 11 **characterised in that** the power electronic module (2) includes a first printed circuit board (1a) as set forth in claim 8, a second printed circuit board (1b) as set forth in claim 9 and three third printed circuit boards (1c) as set forth in claim 10.

13. A power electronic module as set forth in claim 12 **characterised in that** the printed circuit boards (1a, 1b, 1c) are arranged substantially stacked, wherein the three third printed circuit boards (1c) are arranged, preferably in mutually juxtaposed relationship, between the first printed circuit board (1a) and the second printed circuit board (1b).

14. A power electronic module as set forth in claim 12 or 13 **characterised in that** the power electronic module (2) is in the form of a high-current multiphase power bridge, wherein three transistors, preferably IGBTs, and three free-wheeling diodes are mounted, preferably soldered, on the at least one surface (3a) of the first printed circuit board (1a) and/or the second surfaces (3b) of the three third printed circuit boards (1c), and wherein three transistors, preferably IGBTs, and three free-wheeling diodes are mounted, preferably soldered, on the at least one surface (3a) of the second printed circuit board (1b) and/or the first surfaces (3a) of the three third printed circuit boards (1c).

15. A method for producing a printed circuit board (1a, 1b, 1c) as set forth in one of claims 1 through 10 **characterized in that** a conductor paste is applied at least region-wise to a surface (3a, 3b) of the substrate (3), in a first firing phase the conductor paste is exposed to a substantially continuously increasing firing temperature, wherein the firing temperature is increased to a predeterminable maximum firing temperature of less than about 660 °C, in a second firing phase the conductor paste is exposed substantially to the predeterminable maximum firing temperature for a predeterminable period of time, in a cooling phase the conductor paste is cooled down and in a post-treatment phase a surface of the conductor paste is mechanically post-treated, preferably brushed.

## Revendications

1. Carte de circuit imprimé (1a, 1b, 1c), en particulier pour un module électronique de puissance (2), comprenant un substrat électriquement conducteur (3) muni d'un élément de connexion (12) pour connecter la carte de circuit imprimée (1a, 1b, 1c) à une source de courant continu ou à un moteur triphasé, le substrat (3) étant constitué au moins partiellement, de préférence totalement, d'aluminium et/ou d'un alliage d'aluminium, **caractérisée en ce qu'**au moins une surface de circuit imprimé (4a, 4b) prenant la forme d'une couche électriquement conductrice, déposée de préférence par un procédé d'impression, de manière particulièrement préférée par un procédé de sérigraphie, est disposée sur au moins une surface (3a, 3b) du substrat électriquement conducteur (3), la surface de circuit imprimé (4a, 4b) étant en contact électrique direct avec le substrat électriquement conducteur (3).

2. Carte de circuit imprimé selon la revendication 1, **caractérisée en ce que** la au moins une surface (3a, 3b) du substrat électriquement conducteur (3) est de configuration essentiellement plane.

3. Carte de circuit imprimé selon la revendication 1 ou 2, **caractérisée en ce que** la surface de circuit imprimé (4a, 4b) est constituée essentiellement de cuivre.

4. Carte de circuit imprimé selon l'une des revendications 1 à 3, **caractérisée en ce que** la surface de circuit imprimé (4a, 4b) comprend un verre constitué du système PbO-B₂O₃-SiO₂ et/ou un verre comprenant du Bi₂O₃.

5. Carte de circuit imprimé selon l'une des revendications 1 à 4, **caractérisée en ce que** la surface de circuit imprimé (4a, 4b) présente une épaisseur de 25 µm à 125 µm, de préférence de 90 µm à 110 µm.

6. Carte de circuit imprimé selon l'une des revendications 1 à 5, **caractérisée en ce qu'**au moins une surface d'isolant (5) prenant la forme d'une couche diélectrique, déposée de préférence par un procédé d'impression, de manière particulièrement préférée par un procédé de sérigraphie, est disposée sur la au moins une surface (3a, 3b) du substrat électriquement conducteur (3), la au moins une surface d'isolant (5) étant de préférence au moins partiellement adjacente à la au moins une surface de circuit imprimé (4a, 4b), entourant de préférence la au moins une surface de circuit imprimé (4a, 4b).

7. Carte de circuit imprimé selon la revendication 6, **caractérisée en ce qu'**au moins une surface de connexion (6) prenant la forme d'une couche électriquement conductrice est disposée sur la au moins une couche d'isolant (5).

8. Carte de circuit imprimé selon l'une des revendications 1 à 7, **caractérisée en ce qu'**une multitude de surfaces de circuit imprimé (4a, 4b), de préférence six surfaces de circuit imprimé (4a, 4b), sont disposées sur la au moins une surface (3a, 3b) du substrat électriquement conducteur (3), les surfaces de circuit imprimé (4a, 4b) étant de préférence entourées d'une couche d'isolant (5).

9. Carte de circuit imprimé selon la revendication 8, **caractérisée en ce qu'**une multitude de surfaces de connexion (6), de préférence trois surfaces de connexion (6) sont disposées sur la couche d'isolant (5).

10. Carte de circuit imprimé selon l'une des revendications 1 à 7, **caractérisée en ce qu'**une multitude de surfaces de circuit imprimé (4a, 4b), de préférence deux surfaces de circuit imprimé (4a, 4b), sont disposées sur une première surface (3a) du substrat électriquement conducteur (3), et qu'une multitude de surfaces de circuit imprimé (4a, 4b), de préférence deux surfaces de circuit imprimé (4a, 4b), ainsi qu'au moins une surface d'isolant (5) sont disposées sur une deuxième surface (3b) du substrat électriquement conducteur (3), une surface de connexion (6) étant disposée sur la au moins une surface d'isolant (5).

11. Module électronique de puissance (2) comprenant au moins une carte de circuit imprimé (1a, 1b, 1c) selon l'une des revendications 1 à 10.

12. Module électronique de puissance selon la revendication 11, **caractérisé en ce que** le module électronique de puissance (2) comprend une première carte de circuit imprimé (1a) selon la revendication 8, une deuxième carte de circuit imprimé (1b) selon la revendication 9 et trois troisièmes cartes de circuit imprimé (1c) selon la revendication 10.

13. Module électronique de puissance selon la revendication 12, **caractérisé en ce que** les cartes de circuit imprimé (1a, 1b, 1c) sont disposées essentiellement en empilement, les trois troisièmes cartes de circuit imprimé (1c) étant disposées, de préférence les unes à côté des autres, entre la première carte de circuit imprimé (1a) et la deuxième carte de circuit imprimé (1b).

14. Module électronique de puissance selon la revendication 12 ou 13, **caractérisé en ce que** le module électronique de puissance (2) est configuré sous la forme d'un pont de puissance polyphasé à haute tension, trois transistors, de préférence des IGBT, et trois diodes de roue libre étant disposées, de préférence soudées, sur la au moins une surface (3a) de la première carte de circuit imprimé (1a) et/ou sur la deuxième surface (3b) des trois troisièmes cartes de circuit imprimé (1c) et trois transistors, de préférence des IGBT, et trois diodes de roue libre étant disposées, de préférence soudées, sur la au moins une surface (3a) de la deuxième carte de circuit imprimé (1b) et/ou sur les premières surfaces (3a) des trois troisièmes cartes de circuit imprimé (1c).

15. Procédé de fabrication d'une carte de circuit imprimé (1a, 1b, 1c) selon l'une des revendications 1 à 10, **caractérisé en ce qu'**une pâte de circuit imprimé est déposée au moins par endroits sur une surface (3a, 3b) du substrat (3), la pâte de circuit imprimé est soumise à une température de calcination qui augmente essentiellement en continu au cours d'une première phase de calcination, la température de calcination étant portée à une température de calcination prédéfinie maximale inférieure à environ 660 °C, la pâte de circuit imprimé est soumise essentiellement à la température de calcination maximale prédéfinie pendant une durée prédéfinie au cours d'une deuxième phase de calcination, la pâte de circuit imprimé est refroidie au cours d'une phase de refroidissement, et une surface de la pâte de circuit imprimé est post-traitée mécaniquement, de préférence polie, au cours d'une phase de post-traitement.
